# EUROPEAN PATENT APPLICATION

(11) **EP 4 428 915 A1**
(43) Date of publication of application: **11.09.2024**
(21) Application number: 23160696.3
(22) Date of filing: 08.03.2023
(51) Int. Cl.: H01L 23/373, H01L 29/16

(54) **SIC ASSEMBLY, POWER SEMICONDUCTOR DEVICE AND METHOD FOR PRODUCING A SIC ASSEMBLY FOR A POWER SEMICONDUCTOR DEVICE**

(71) Applicant: Hitachi Energy Ltd, 8050 Zürich (CH)
(72) Inventor: MIHAILA, Andrei, 5415 Rieden (CH); BAUER, Friedhelm, 6714 Semione (CH); SUNDARAMOORTHY, Vinoth, 5430 Wettingen (CH)
(74) Representative: Epping - Hermann - Fischer

(57) **Abstract**

An assembly (1) for a power semiconductor device (10) is provided, wherein
- the assembly (1) comprises a main body (1M) based on SiC and a plurality of vias (1V) based on an electrically conductive material,
- the main body (1M) comprises a first layer (11) having a first thickness (11T) and a second layer (12) having a second thickness (12T), the second thickness (12T) being smaller than the first thickness (11T),
- the first layer (11) and the second layer (12) are formed from SiC, the first layer (11) having a higher n-doping concentration than the second layer (12), and
- the vias (1V) extend along a vertical direction from a bottom side (11B) of the first layer (11) partially into the first layer (11) towards the second layer (12), the vias (1V) not extending into the second layer (12).

Moreover, a power semiconductor device (10) comprising such an assembly (1) and a method for producing such an assembly (1) and a method are provided.

## Description

The present disclosure relates to a SiC assembly, a power semiconductor device and a method for producing a SiC assembly for a power semiconductor device.

Conventional low voltage SiC devices provide very low on-state voltage drop required by certain applications such as event switching applications. However, switches shall withstand high current pulses for an extended lapse of time ranging from few µs to few seconds. This puts high demands on the so-called *"*single event*"* turn-off capability not only because of high turn-off current densities and/or long pulse lengths but also because of very high temperature swings of the whole switch affecting both the chip and the package.

The realm of recent SiC technology and material properties complicates this situation since current die sizes are limited to typical values for instance not exceeding 50 mm² because of the crystal defect densities and their limiting effect on production yield and therefore die cost. In the present situation, it is thus desired to fully optimize the potential of SiC devices, for instance SiC switches regarding the on-resistance. Thus, for keeping the SiC die area as low as possible for economic reasons, current densities under normal operating conditions shall be pushed as high as possible. This, however, results in extremely high current densities during the high current event leading to intense self-heating of the semiconductor chip and its package. While the semiconductor material SiC is very well able to operate at high temperatures, under vacuum at up to 600 K or higher, state-of-the-art packages and the materials used to make them will not allow to exceed maximum operating temperatures for silicon devices by much. In the case of SiC device, which are used for instance in event switching applications, there is thus a strong interest to add heat capacity to the device as much as possible. This disclosure intends to reach this goal by making use of a highly heat conductive SiC layer on which for instance a voltage sustaining drift layer of a power semiconductor device, for example of a switch device, is applied or grown.

Embodiments of the disclosure, for instance as claimed in the independent claims, address the above shortcomings in the art in whole or in part. Further embodiments of the SiC assembly, the power semiconductor device and as well as of the method for producing a SiC assembly for a power semiconductor device are subject-matter of the further claims.

According to an embodiment of an assembly for a power semiconductor device, it comprises a main body based on SiC and a plurality of vias based on an electrically conductive material. The main body comprises a first layer having a first thickness and a second layer having a second thickness, wherein the second thickness is smaller than the first thickness. The first layer and the second layer are formed from SiC. The first layer can have a higher n-doping concentration than the second layer. The vias extend along a vertical direction from a bottom side of the first layer partially into the first layer towards the second layer, wherein the vias do not extend into the second layer.

The first layer and the second layer have different n-doping concentration. However, the first layer and the second layer may be formed from the same material, for instance from 4H-SiC. It is, however, possible that the second layer is formed from 4H-SiC, and the first layer is formed from 3C-SiC or poly-SiC. For instance, the second layer is a drift layer. Such a drift layer can be epitaxially grown on the first layer. The first layer can be a substrate which carries the second layer and mechanically stabilizes the assembly.

The vias can be trenches which are fully filed with the electrically conductive material. It is also possible that the vias can are trenches which are partly filled with the electrically conductive material. For instance, only inner walls of the trenches are covered with the electrically conductive material. In this case the trenches may comprise regions which are filled with a gaseous medium, for instance with air.

The goal of this disclosure is to make use a thicker first layer allowing reduced self-heating without having the disadvantage of increasing simultaneously a total resistance of an arrangement, for instance of the power semiconductor device. This goal is reached providing holes or trenches in two- or three-dimensional arrangements in the first layer which are filled with a metal with high electrical conductivity and high thermal conductivity, for instance with aluminium, copper or silver due to their high intrinsic electrical conductance or with an appropriate form of graphite. The number of holes or trenches for each assembly may be at least 4, 6, 8, 10, 16, 20, 50 or at least 100. According to a further embodiment of the assembly, a ratio of the vertical first thickness to the vertical second thickness is from 1.5 to 250. The first thickness can be from 100 um to 1000 um. The second thickness can be from 2 um to 200 um.

A vertical direction is understood to mean a direction which is directed perpendicular to a bottom surface of the first layer. A lateral direction is understood to mean a direction which is parallel to the bottom surface of the first layer. The vertical direction and the lateral direction are orthogonal to each other. The bottom surface of the first layer is located at the bottom side of the first layer and is a lateral surface which can be defined by one vector directing along a length of the assembly and by another vector directing along a width of the assembly.

According to a further embodiment of the assembly, a maximal vertical distance between the second layer and the vias is from 0.6 um to 250 um, for instance from 1 um to 250 um. For example, the first thickness is larger than or equal 300 um or 350 um. The second thickness is for instance smaller than or equal to 55 um or 25 um or 10 um. The first thickness and the second thickness, however, are not limited thereto.

According to a further embodiment of the assembly, a ratio of an average vertical height of the vias to the first thickness of the first layer is at least 0.5, for instance at least 0.6, 0.7, 0.8 or at least 0.9. In other words, the vias extend into at least 50%, 60%, 70%, 80% or at least 90% of the total vertical thickness of the first layer. The vias, however, do not extend throughout the first layer along the vertical direction. In this sense, the vias extend along the vertical direction from the bottom side of the first layer only partially into the first layer towards the second layer.

According to a further embodiment of the assembly, the vias have a lateral average width from 3 um to 150 um, for instance from 6 um to 150 um or from 10 um to 150 um. The vias have a lateral average length which is larger than the lateral average width. Along lateral directions, at least some of the vias or all the vias can be fully or partly enclosed by the first layer. It is possible, however, that along one lateral direction, at least some of the vias or all the vias can extend from one first side surface of the first layer to another side surface of the first layer for instance opposite to the first side surface of the first layer. In this case, the vias can be exposed not only at the bottom side of the first layer but also on at least partially one side surface or on two side surfaces of the first layer.

According to a further embodiment of the assembly, along lateral directions, the vias are fully surrounded by the first layer. In this case, the vias are not exposed on side surfaces of the first layer.

According to a further embodiment of the assembly, the first layer has a first side surface and a second side surface. Along lateral direction, at least one, several of vias or all the vias can extend from the first side surface to the second side surface of the first layer. For instance the first side surface is opposite to the second side surface. In this case, it is possible that the vias have lateral lengths which are equal to or larger than a lateral width or a lateral length of the first layer. Along a lateral direction, the vias can extend along the width or along the length of the first layer. It is also possible that the first side surface is adjacent to the second side surface. In this case, along a lateral direction, the vias can extend from the first side surface to the adjacent second side surface. Along a lateral direction, the vias are not parallel to the orientation of the width or the length of the first layer.

According to a further embodiment of the assembly, it further comprises a heat sink formed for instance from a metal. The main body is arranged on the heat sink, for instance directly on the heat sink. The heat sink has a vertical thickness which is for instance larger than a sum of the first thickness and the second thickness.

The heat sink can be a thick metal plate, for instance a copper plate, which serves as an efficient main heat sink for the assembly or for the semiconductor device. The heat sink can have sizes of the same width and/or length of the main body. A vertical thickness of the heat sink can be equal to or larger than 500 um, 1000 µm, 2000 um, 3000 um or 4000 um.

According to a further embodiment of the assembly, the heat sink has a larger cross section than the main body so that in a top view of the heat sink, the main body fully overlaps with the heat sink. It is, however, also possible for the heat sink to have equal or roughly equal cross section compared to the cross section of the main body.

According to a further embodiment of the assembly, it further comprises a SiC substrate, wherein the second layer is arranged between the SiC substrate and the first layer. The SiC substrate has a vertical thickness, wherein a ratio of the SiC substrate to the second thickness being can be from 1.5 to 250. The SiC substrate is for instance void of any vias formed from an electrically conductive material.

The SiC substrate and the main body may be separated by a metal layer, for instance an aluminium layer or a copper layer, which can constitute an electrode, for instance a cathode of the assembly or of the power semiconductor device. The SiC substrate acts as a top-side cooler and is for instance not electrically active. For this reason, no vias, holes or trenches are formed within the SiC for reducing possible resistive voltage drop. For instance, a thermal boundary electrode is present at the bottom side of the assembly.

According to a further embodiment of the assembly, the vias have cross sections whose sizes vary along the vertical direction. For instance, the size of the cross section of each of the vias increases with decreasing distance from the bottom side of the first layer. Due to this geometry of the vias, the vias can be filled with the electrically conductive material in an efficient and simplified manner.

According to one embodiment of a power semiconductor device, it comprises an assembly, in particular the assembly described here in this disclosure. The assembly comprises a main body based on SiC and a plurality of vias based on an electrically conductive material. The main body comprises a first layer having a first thickness and a second layer, wherein the second thickness is smaller than the first thickness. The first layer and the second layer are formed from SiC, wherein the first layer has a higher n-doping concentration than the second layer. The vias extend along a vertical direction from a bottom side of the first layer partially into the first layer towards the second layer, wherein the vias do not extend into the second layer. The second layer comprises functional regions configured to carry out functionality of the power semiconductor device. The functional regions can comprise p- and n-regions for instance of a transistor. For instance, the second layer is formed as a drift layer.

According to a further embodiment of the power semiconductor device, it is formed as a metal-oxide-silicon field-effect transistor (MOSFET), a junction field-effect transistor (JFET), an insulated-gate bipolar transistor (IGBT), a Schottky diode, a Junction Barrier Schottky (JBS) diode or as a SiC power device for event switching. The second layer can comprise the functional regions of such a transistor or diode.

According to one embodiment of a method for producing an assembly for a power semiconductor device, a wafer is provided. The wafer comprising at least one main body based on SiC. The wafer or the main body comprises a first layer having a first thickness and a second layer having a second thickness, wherein the second thickness is smaller than the first thickness. The first layer and the second layer are formed from SiC. The first layer can have a higher n-doping concentration than the second layer. According to the method, a plurality of trenches are formed which extend along a vertical direction from a bottom side of the first layer partially into the first layer towards the second layer, wherein the trenches do not extend into the second layer. The trenches are filled with an electrically conductive material for forming a plurality of vias, wherein the vias extend along the vertical direction from the bottom side of the first layer partially into the first layer towards the second layer and do not extend into the second layer.

According to a further embodiment of the method, the wafer is singulated along singulating lines into a plurality of main bodies, wherein at least some of the singulating lines cut through the vias so that at least some of the singulated main bodies comprise side surfaces which comprise side surfaces of the vias.

According to a further embodiment of the method, the wafer is singulated along singulating lines into a plurality of main bodies, wherein at least some of the singulating lines do not cut through the vias so that at least some of the singulated main bodies comprise all side surfaces being void of side surfaces of the vias.

The present disclosure comprises several aspects of an assembly for a power semiconductor device, of a power semiconductor device comprising such an assembly and of a method for producing such an assembly for such a power semiconductor device on the basis of their embodiments and examples. Every feature described with respect to one of the aspects is also disclosed herein with respect to the other aspect, even if the respective feature is not explicitly mentioned in the context of the specific aspect. For example, the method described in this disclosure is directed to a method for producing the assembly described here, and the power semiconductor device described in this disclosure can comprise the assembly described here. Thus, features and advantages described in connection with the assembly can be used for the method and for the power semiconductor device, and vice versa.

While the disclosure is amenable to various modifications and alternative forms, specifics thereof are shown by way of example in the figures and will be described in detail. It should be understood, however, that the intention is not to limit the disclosure to the particular described embodiments and examples. On the contrary, the intention is to cover all modifications, equivalents, and alternatives falling within the scope of the disclosure defined by the appended claims.

The accompanying figures are included to provide a further understanding. In the figures, elements of the same structure and/or functionality may be assigned to the same reference signs. It is to be understood that the examples shown in the figures are illustrative representations and are not necessarily true to scale.
Figure 1A schematically shows a general concept of an assembly for a power semiconductor device in cross-sectional view according to an example of the disclosure.
Figures 1B and 1C show - in top view on a bottom side of the assembly - different arrangements of vias according to different examples of the assembly.
Figures 2, 3, 4, 5, 6 and 7 show further examples of the assembly or of the power semiconductor device.
Figure 8A, 8B, 8C and 8D show some simulation results of different examples of the assembly.
Figures 9A, 9B and 9C show some exemplary method steps of a method for producing at least one assembly for a power semiconductor device.
Figures 10A, 10B, 11A, 11B, 12 and 13 show some exemplary method steps of different examples for a method for producing a plurality of assemblies for a power semiconductor device.

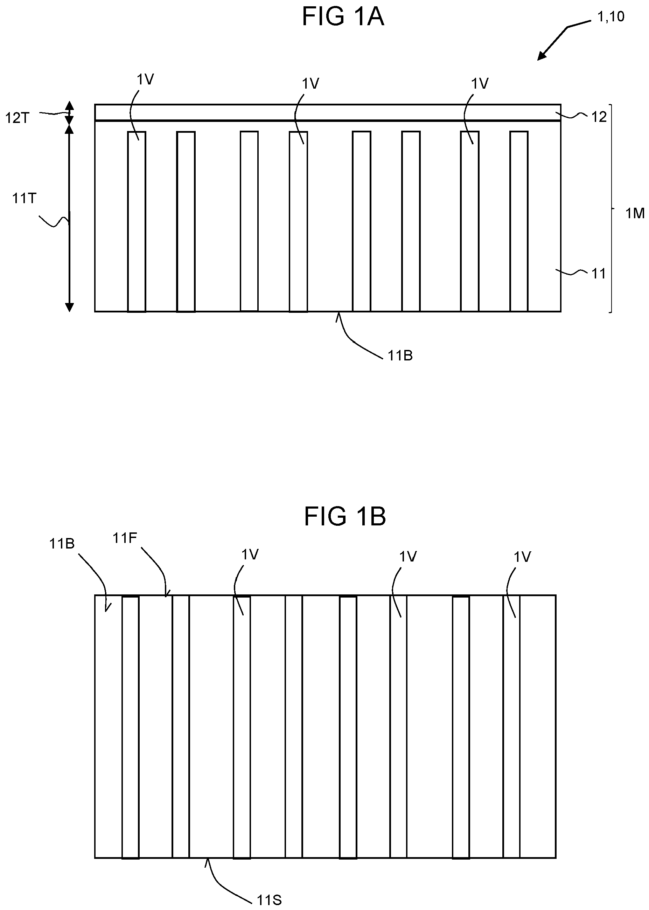

Figure 1A shows a sectional view of an assembly 1 for a power semiconductor device 10 according to one exemplary embodiment. The assembly 1 comprises a main body 1M comprising a first layer 11 having a first thickness 11T and a second layer 12 having a second thickness 12T. The main body 1M is based on SiC. The first layer 11 is formed from SiC, for instance from 4H-SiC, 3C-SiC or poly-SiC. The second layer 12 is formed from SiC, for instance from 4H-SiC. The first layer 11 has a higher n-doping concentration than the second layer 12. As shown in Figure 1A, the second thickness 12T is smaller than the first thickness 11T. The second layer 12 can be directly adjacent to the first layer 11.

A ratio 11T/12T of the first thickness 11T to the second thickness 12T can be from 1.5 to 250, for instance from 5 to 250, from 5 to 200, from 5 to 100, from 5 to 50, from 5 to 25, from 5 to 25. For instance, the ratio 11T/12T is larger or equal 5, 10, 30, 50 or 100. For instance, the ratio 11T/12T is larger than or equal 1.5 and 5 but can be smaller or equal 10, 15, 20, 30, 50 or 100.

The first thickness 11T can be from 100 um to 1000 um, for instance from 100 um to 800 um, from 100 um to 600 um, from 100 um to 400 um. For instance, the first thickness 11T is 600 µm ± 300 um or 600 µm ± 200 um or 600 µm ± 50 um.

The second thickness 12T can be from 2 um to 200 um, for instance from 2 um to 100 um, from 2 um to 50 um, from 2 um to 10 um. For instance, the second thickness 12T is 50 µm ± 10 um or 30 µm ± 10 um or 10 µm ± 5 µm.

For instance, the first thickness 11T is larger than or equal 300 um or 500 um, and the second thickness 12T is smaller than or equal to 55 um, 35 um, 20 um or 10 um.

The assembly 1 comprises a plurality of vias 1V which are based on an electrically conductive material. For instance, the vias 1V are trenches which are filled for instance with aluminium, copper or silver. The vias 1V extend along a vertical direction from a bottom side 11B of the first layer 11 partially into the first layer 11 towards the second layer 12, wherein the vias 1V do not extend into the second layer 12 but stop in front of the second layer 12.

A maximal vertical distance between the second layer 12 and the vias 1V can be from 0.6 um to 250 um, for instance from 1 um to 250 um, for instance from 1 um to 150 um, from 1 um to 100 um, from 1 um to 50 um, from 1 um to 30 um or from 1 um to 10 um.

As shown in Figure 1A, the vias 1V only partially extend into the first layer. It is possible that a ratio of an average vertical height of the vias 1V to the first thickness 11T of the first layer 11 is at least 0.5, 0.6, 0.7, 0.8 or at least 0.9, for instance between 0.8 and 0.98.

The vias 1V can have a lateral average width from 3 um to 150 um, for instance from 6 um to 150 um, from 10 um to 150 um, for instance from 10 um to 100 um, from 10 um to 80 um, from 10 um to 60 um, from 10 um to 40 um or from 10 um to 20 um. The vias 1V can have a lateral average length which is larger than the lateral average width. The lateral of the vias 1V can be the lateral length or lateral width of the assembly 1.

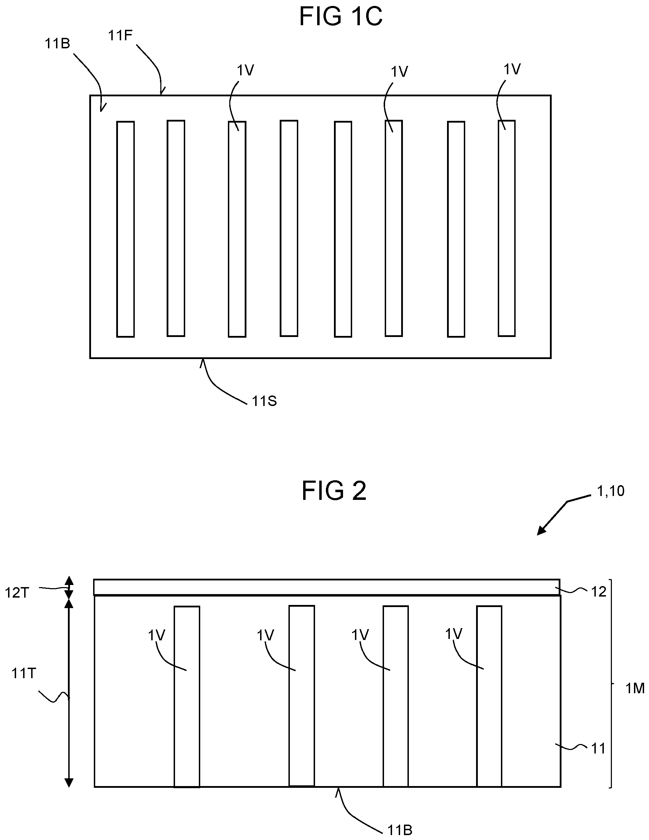

For instance, in a top view on the bottom side 11B of the first layer 11 as shown for instance in Figures 1B and 1C, the vias 1V are strip-shaped. The vias 1V are parallel to each other. A ratio of the lateral length to the lateral width of one via 1V or of the vias 1V can be from 1.5 to 50, 1.5 to 30, 1.5 to 10 or 1.5 to 5. It is also possible that the vias 1V, in a top view on the bottom side 11B of the first layer 11, can have another shapes, for instance a square, circular, trapezoidal shape or other regular and irregular shapes.

As shown in Figure 1A, the assembly 1 comprises a plurality of vias 1V, for instance eight vias 1V, which - as shown in Figure 1B - extend along a lateral direction from a first side surface 11F to a second side surface 11S of the first layer 11, wherein the first side surface 11F is opposite to the second side surface 11S. Hence, the vias 1V can have a lateral length which is equal or roughly equal to a width of the first layer 11. On the first side surface 11F and/or on the second side surface 11S, the vias 1V can be partially exposed. The eight vias 1V are parallel to each other.

In deviation from Figure 1B, it is possible that the vias 1V are rotated by an angle of 90°. In this case, the vias 1V can have a lateral length which is equal or roughly equal to a length of the first layer 11. Other orientations of the vias 1V are also possible. For instance, along a lateral direction, the vias 1V can extend from the first side surface 11F or from the second side surface 11S to another side surface of the first layer 11, wherein the other side surface of the first layer is adjacent to the first side surface 11F or to the second side surface 11S.

Compared to the vias 1V in Figure 1B, in a top view on the bottom side 11B of the first layer 11, the vias 1V in Figure 1C have the same lateral orientations. The vias 1V in Figure 1C, however, do not extend to any side surfaces of the first layer 11. Thus, in lateral directions, the vias 1V are fully enclosed or fully surrounded by the first layer 11.

In deviation from Figure 1C, it is possible that the vias 1V can have other orientations along the lateral directions, for instance the vias 1V are rotated by an angle of 90° or by another angle.

In deviation from Figures 1A, 1B and 1C, other arrangements and/or other number of the vias 1V are/is also possible. For instance, the number of the vias 1V is larger or smaller than eight, for instance larger than 10, 15, 20, 30, 40 or 50. A combination of the vias 1V as shown in Figures 1B and 1C is also possible. In a top view on the bottom side 11B of the first layer 11, the vias 1V can be arranged in a matrix-like manner, i.e. can be arranged in a plurality of columns and rows. It is also possible that only one end or both ends of some of the vias 1V are partially exposed on the side surfaces of the first layer 11 and some other vias 1V are fully surrounded by the first layers 11 and therefore are not exposed on any of the side surfaces of the first layer 11. The assembly 1 or the power semiconductor device 10 shown in Figure 2 is basically identical to the assembly 1 or the power semiconductor device 10 shown in Figure 1A with the exception that Figure 2 shows only four vias 1V.

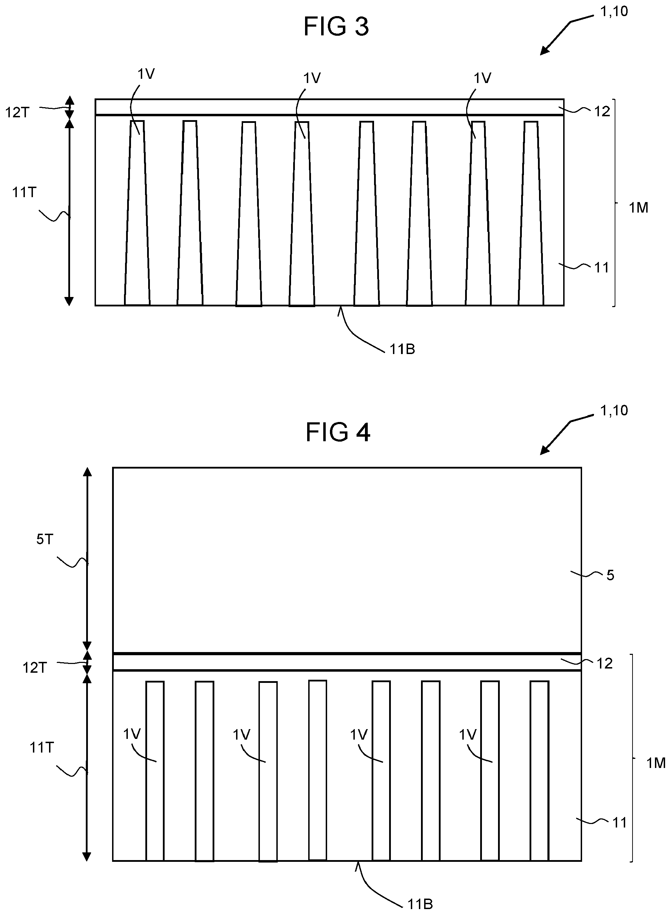

The assembly 1 or the power semiconductor device 10 shown in Figure 3 is basically identical to the assembly 1 or the power semiconductor device 10 shown in Figure 1A with the exception that the vias 1V have cross sections whose sizes vary along the vertical direction. The size of the cross section of each of the vias 1V increases with decreasing distance to the bottom side 11B of the first layer 11. Here, inner walls of the vias 1V may be sloped in order to facilitate metallization for instance at the end of semiconductor processing. Thus, at the bottom side 11B, each of the vias 1V has the largest cross section or the largest opening. This simplifies the filling of the material of the vias 1V and can ensure that the vias 1V can be fully filled with an electrical material like aluminium, copper, silver or the like.

The assembly 1 or the power semiconductor device 10 shown in Figure 4 is basically identical to the assembly 1 or the power semiconductor device 10 shown in Figure 1A with the exception that a substrate 5 is arranged on the main body 1M. The substrate 5 and the main body 1M can have the same geometrical sizes, for instance the same length, width and thickness. It is also possible for the substrate 5 to have smaller or greater vertical thickness 5T than the main body 1M. The substrate 5 can be formed from SiC. For instance, the substrate 5 is formed from the same material as the first layer 11 of the main body 1M.

As shown in Figure 4, the second layer 12 is arranged between the SiC substrate 5 and the first layer 11. The substrate 5 has a vertical thickness 5T, wherein a ratio 5T/12T of the substrate 5 to the second thickness 12T can be from 1.5 to 250, for instance from 5 to 250, from 5 to 200, from 5 to 100, from 5 to 50, from 5 to 25, from 5 to 25. For instance, the ratio 5T/12T is larger or equal 5, 10, 30, 50 or 100. For instance, the ratio 5T/12T is larger than or equal 1.5 and 5 but can be smaller or equal 10, 15, 20, 30, 50 or 100.

A ratio 5T/11T of the substrate 5 to the first thickness 11T can be from 0.3 to 3, for instance from 0.5 to 3, from 1 to 3, from 0.5 to 2, from 0.5 to 1.5, from 0.75 to 1.25, from 0.8 to 1.2 or from 0.9 to 1.1. Compared to the main body 1M or to the first layer 11, the substrate 5, however, is void of any vias formed from an electrically conductive material.

The substrate 5 may act as a top-side cooler. The substrate 5 and the main body 1M may be separated by a metal layer, for instance an aluminium or a copper layer, which may constitute an electrode, for instance a cathode of the assembly 1 or of the power semiconductor device 10. The substrate 5 acting as a top-side cooler is not electrically active. For this reason, no vias, holes or trenches are required for reducing a resistive voltage drop. A thermal boundary electrode can be present at a bottom side of the assembly 1 or of the power semiconductor device 10, for example at the bottom side 11B of the first layer 11 of the main body 1M.

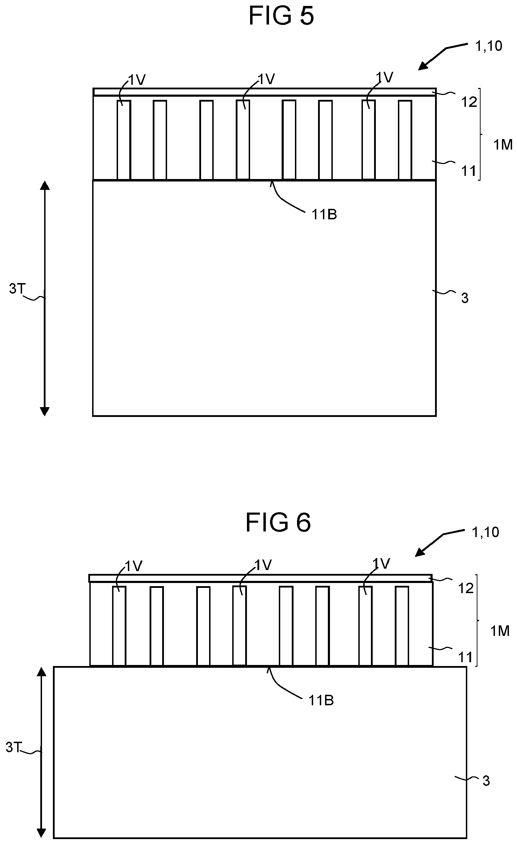

The assembly 1 or the power semiconductor device 10 shown in Figure 5 is basically identical to the assembly 1 or the power semiconductor device 10 shown in Figure 1A with the exception that the main body 1M is arranged on a heat sink 3. The heat sink 3 can be formed from a metal, for instance from copper. The heat sink 3 has a vertical thickness 3T which is larger than a sum of the first thickness 11T and the second thickness 12T, for instance at least 1.5, 2, 3 or 5 times larger than a sum of the first thickness 11T and the second thickness 12T.

Here, the heat sink 3 acts as a main heat sink or as a main cooler of the assembly 1 or of the power semiconductor device 10. The presence of the heat sink 3 results in a reduction of self-heating and improvement of current density. These effects are enhanced if the heat sink 3 is used in combination with the vias 1V formed in the first layer 11. As shown in Figure 5, the main body 1M and the heat sink 3 may have substantially the same geometrical sizes with regard to lateral length and/or lateral width.

The assembly 1 or the power semiconductor device 10 shown in Figure 6 is basically identical to the assembly 1 or the power semiconductor device 10 shown in Figure 5 with the exception that heat sink 3 has a larger cross section than the main body 1M. In a top view on the heat sink 3, the main body 1M can fully overlap with the heat sink 3. For example, the lateral length and the lateral width of the heat sink 3 are larger than the lateral length and the lateral width of the main body 1M, respectively. The heat sink 3 shown in Figure 5 and the heat sink shown in Figure 6 may have the same volume. It has been found out that compared to the heat sink 3 shown in Figure 5, the use of the heat sink 3 shown in Figure 6 results in further reduction of self-heating and improvement of current density.

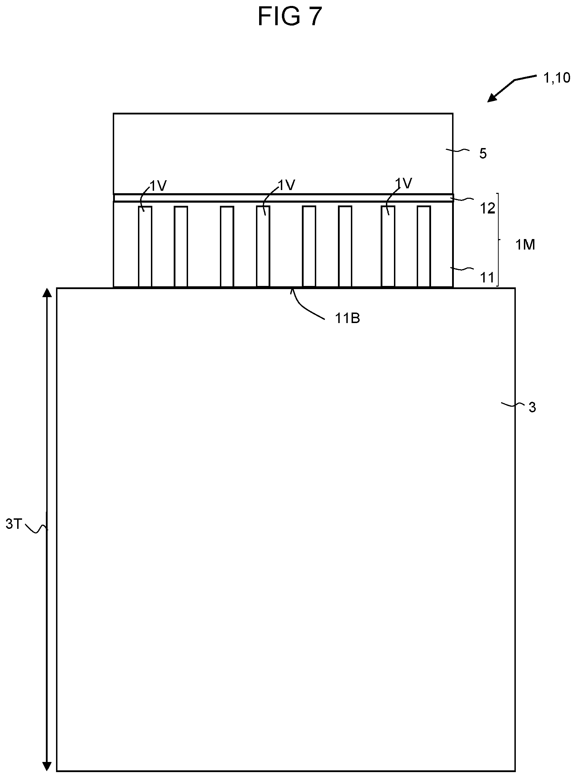

The assembly 1 or the power semiconductor device 10 shown in Figure 7 is basically identical to the assembly 1 or the power semiconductor device 10 shown in Figure 4 with the exception that the assembly 1 or the power semiconductor device 10 shown in Figure 7 comprises a heat sink 3 as shown in Figure 6.

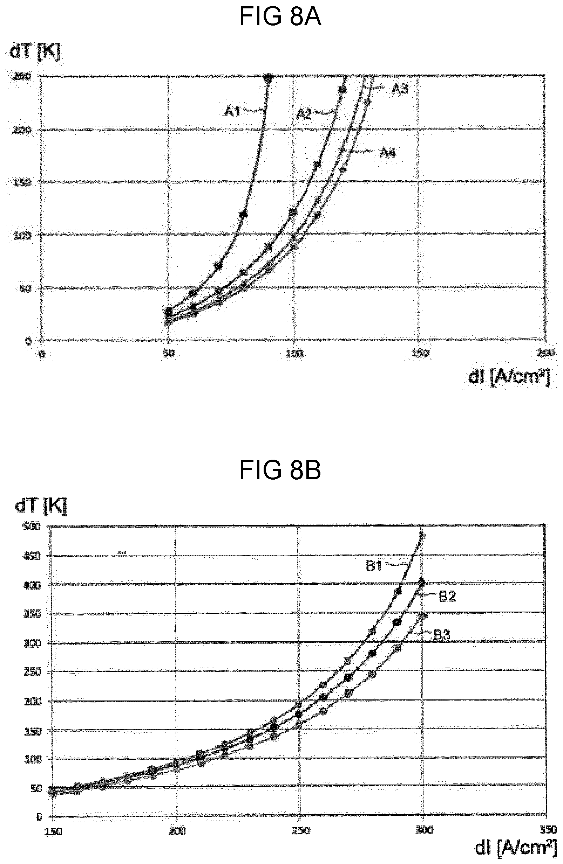

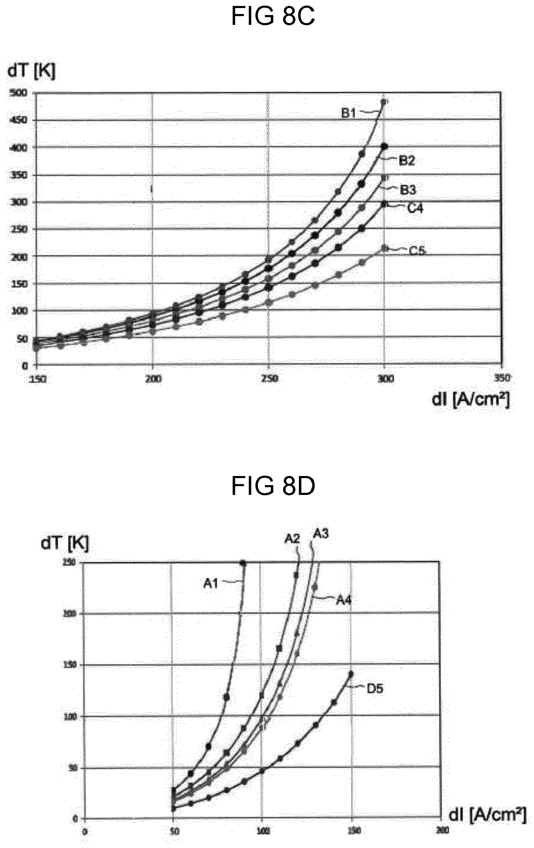

In connection with Figures 8A, 8B, 8C and 8D, some simulation results are shown.

A procedure to manufacture SiC power devices can depart with the first layer 11 being a thick and highly doped SiC layer. For example, in the case of SiC unipolar power devices for 600 V and 1.2 kV applications, the second layer 12 being a thin, lowly doped voltage sustaining SiC drift layer, can be epitaxially grown on top of the first layer 11. The thickness of the drift layer may range from a few um up to about 10 um for the voltage classes mentioned above which is very thin compared to the thick first layer 11 having a vertical thickness 11T of 100 um, 200 um, 300 um or more.

As the resistance contribution of the first layer 11 cannot be neglected, for instance at such low voltage class devices, so far the thickness of the first layer 11 will be thinned in order to allow the minimum on-state voltage drop to be reached.

For the self-heating simulation, this assembly 1 or this power semiconductor device 10 being for instance a resistor has two electrical contacts used to energize the arrangement. Since aluminium is widely used for metal contacts in power semiconductor devices, the simulated contacts are chosen to be formed from aluminium. On the bottom side 11B of the first layer 11, there is a metallization being a thermal electrode on which a thermal boundary condition is implied. An initial temperature is set to be 300 K in this example and the thermal electrode is characterized by a thermal surface resistance of 10 cm²K/W. This value of the thermal surface resistance is exemplary of mounting the power semiconductor device on a small heat sink without forced cooling.

In the simulations discussed here, a surface temperature of the thermal boundary of 300 K is used. In the self-heating simulations, a current pulse of a length of 3 seconds is subjected onto the assembly 1 or the power semiconductor device 10 comprising the first layer 11 and the second layer 12. The height of the current density pulse is variable and will thus yield different maximum device temperatures at the end of the current pulse.

For comparison purposes, in 2D-numerical simulations, a typical conventional thickness of the first SiC layer 11 is chosen to be 100 um and a typical conventional thickness of the second SiC layer 12 being a drift layer is chosen to be 8 um with a resistance typical for a 1.2 kV SiC JFET with 1.4 mΩcm² on-resistance on top of the first layer 11. The width of the first layer 11 and of the second layer is chosen to be 5120 um and a current of variable height is impressed through the second layer 12 and the first layer 11 flowing from top to bottom of the assembly 1. Top and bottom surfaces are electrical contacts, wherein at the bottom surface, there is also a thermal contact which carries a thermal boundary condition T = 300 K.

The results for such a conventional assembly 1 or power semiconductor device 10 are displayed by the curve A1 in Figure 8A, wherein dT denotes the average temperature increase in Kelvin and dI denotes the pulsed current density in A/cm². Here, the first layer 11 is void of any vias.

Curve A2 corresponds to the same configuration of the assembly 1 or of the power semiconductor device 10 as for curve A1 but with a first layer 11 having a thickness 11T of 600 um without any vias 1V.

Curve A3 corresponds to the same configuration of the assembly 1 or of the power semiconductor device 10 as for curve A2 but with four vias 1V as shown in Figure 2. Here, each of the four vias 1V is in the form of trench having a lateral width of 40 um and a vertical height of 590 um which is assumed to be filled with copper. They provide an electrical bypass from the second layer 12 being a drift layer at the top to an electrical contact at the bottom side 11B of the first layer 11. A thermal boundary/electrode is also located at the bottom side 11B of the first layer 11.

Curve A4 corresponds to the same configuration of the assembly 1 or of the power semiconductor device 10 as for curve A2 but with eight vias 1V as shown in Figure 1A. Here, each of the eight vias 1V is in the form of trench having a lateral width of 20 um and a vertical height of 590 um which is assumed to be filled with copper. They provide an electrical bypass from the second layer 12 being a drift layer at the top to an electrical contact at the bottom side 11B of the first layer 11. A thermal boundary/electrode is also located at the bottom side 11B of the first layer 11.

As shown in Figure 8A, because of the good thermal properties of silicon carbide, the thicker first layer 11 adds a fair amount of heat capacity. This will lead to a slower increase of the assembly temperature when the current pulse is applied. It has been also observed that there is, however, a second opposed effect taking place, namely: when the thickness 11T of the first layer is increased, the total resistance of the assembly 1 or of the power semiconductor device 10 will become higher. This means that the heat generation caused by the very same current pulse will be higher in the second case. Accordingly, there will be a maximum thickness 11T of the first layer 11, where the final maximum temperature reached after the current pulse will no longer decrease, instead, it will increase again.

In the presence of the vias 1V, however, the reduction of self-heating and the improvement of current density can be ensured even for relatively thick first layer 11. The top of the vias 1V may stop short in front of the second layer 12, for instance in the range of the 1 um to 50 um, here 10 um in the case of curves A3 and A4, thereby contributing a maximum path to bypass the resistance of the first layer 11. The width of the four vias 1V in case of the curve A3 and the width of the eight vias 1V in case of the curve A4 are chosen to be different on purpose: it shows that the width of the vias 1V and the lateral spacing between the vias 1V is a suitable parameter to optimize. Results of self-heating simulations for various configurations are provided by the curves A1 to A4. Although the density of the vias 1V remains at low level, here only 4 or 8 vias 1V over an assembly width of 5120 um, the results provided by the curves A3 and A4 already demonstrate a potential of peak temperature limitation exceeding 100 K when measured against the base case provided by curve A1, especially at higher current density. The peak temperature could be limited further by increasing the number and/or dimensions of vias 1V in the first layer 11.

Thus, already by using a two-dimensional simulation, the effectiveness of this approach has been demonstrated with the configurations shown in Figure 1A and 2. It has been shown that thick first layer 11 having a plurality of vias 1V can retard thermal runaway considerably. For enhance this effect, the density of vias 1V per area can be much higher than that used in the numerical examples presented here.

Figure 8B shows further curves B1, B2 and B3 as a function of temperature increase depending on the current density after 3-second current pulse.

Curve B1 corresponds to the same configuration of the assembly 1 or of the power semiconductor device 10 comprising a first SiC layer 11 having a thickness 11T of 600 um without any vias 1V, a second SiC layer 12 being a drift layer having a thickness of 8 um and further configuration of the assembly 1 or of the power semiconductor device 10 according to curve A2. In addition, the assembly 1 or of the power semiconductor device 10 is arranged on a heat sink 3 being copper plate having a thickness 3T of 4180 um. Such an assembly 1 or a power semiconductor device 10 is shown in Figure 5, but without any vias 1V in the first layer 11.

Curve B2 corresponds to the same configuration of the assembly 1 or of the power semiconductor device 10 as for curve B1 but with a first SiC layer 11 having a thickness 11T of 600 um and four vias 1V as shown in Figure 2. Such an assembly 1 or a power semiconductor device 10 is shown in Figure 5, but with four vias 1V in the first layer 11, wherein each of the four vias 1V is in the form of trench having a lateral width of 40 um and a vertical height of 590 um and is filled with copper.

Curve B3 corresponds to the same configuration of the assembly 1 or of the power semiconductor device 10 as for curve B1 but with eight vias 1V. Such an assembly 1 or a power semiconductor device 10 is shown in Figure 5 with eight vias 1V in the first layer 11, wherein each of the eight vias 1V is in the form of trench having a lateral width of 20 um and a vertical height of 590 um and is filled with copper.

As shown in Figure 8B, using a thick first SiC having the highest density of vias 1V can retard thermal runaway in a most efficient way. This effected is enhanced in the presence of the heat sink 3. According to Figure 8B, maximum temperatures reach after a 3 second current pulse with given current density. Compared to Figure 8A, as shown in Figure 8B, it is apparent that the presence of the heat sink 3 greatly limits the final temperature reached at the end of the current pulse. Here, for a given, allowed temperature increase, the maximum current density can be roughly doubled when a thick copper heat sink 3 as used in the numerical example is added. This can be seen when comparing the curve A4 in Figure 8A to the curve B3 in Figure 8B, for instance at a temperature increase of 150 K.

Figure 8B also shows that the benefit of the thick SiC first layer 11 featuring the vias 1V filled with copper continues to be significant albeit at higher current densities, for instance at 300 A/cm². At lower current densities, for instance at 150 A/cm², the tolerable maximum current density is increased by 10 % or more.

Figure 8C shows curves B1, B2 and B3 already shown in Figure 8B and additional curves C4 and C5.

Curve C4 corresponds to the same configuration of the assembly 1 or of the power semiconductor device 10 as for curve B3 but with a heat sink 3 which exceeds the width or the cross section of the main body 1M as shown in Figure 6. Here, the sizes of the heat sink 3 has been changed from 5120 µm x 4180 um to 10240 µm x 2090 um, wherein the volume of the heat sink 3 remains unchanged.

Compared to the heat sink 3 shown in Figure 5, the heat sink 3 in Figure 6 has a larger width or larger cross section but a smaller thickness 3T. Thus, the volume of the heat sink 3 shown in Figure 5 and the volume of the heat sink 3 shown in Figure 6 can be the same, which is the case for the configuration of the assembly 1 or of the power semiconductor device 10 according to curves B3 and C4. In other word, curve B3 corresponds to of the assembly 1 or of the power semiconductor device 10 shown in Figure 5, and curve C4 corresponds to the assembly 1 or the power semiconductor device 10 shown in Figure 5. For a quantitative evaluation of the additional effect with regard to the dimension of the heat sink 3, it could be seen from the curves B3 and C4 that the wider heat sink 3 with the same volume offers a reduction of about 50 K at a current density of 300 A/cm².

Curve C5 corresponds to the same configuration of the assembly 1 or of the power semiconductor device 10 as for curve C4 with the exception that the assembly 1 or the power semiconductor device 10 comprises a SiC substrate 5, i.e. a top-side cooler, as shown in Figure 7. The SiC substrate 5 can have roughly the same sizes as the first layer 11 or the main body 1M. The substrate 5, however, is free of vias 1V. For the simulation, the SiC substrate and the first SiC layer 11 have the same thickness of 600 um.

Figure 8D is basically identical to Figure 8A, wherein in Figure 8D, an additional curve D5 is shown. The curve D5 corresponds to the same configuration of the assembly 1 or of the power semiconductor device 10 as for curve A4 as shown in Figure 1A with the exception that the assembly 1 comprises the further SiC substrate 5 having the thickness 5T as shown in Figure 4. For numerical simulation, the thickness 5T is chosen to be 600 um. Curve D5 shows that the further substrate 5 can retard thermal runaway further, resulting in a further reduction of self-heating and further improvement of current density.

With the further SiC substrate 5 being a SiC top-side cooler acting as additional heatsink, final maximum temperatures after completion of the current pulse with a pulse width of 3 seconds can be reduced further. The investigated configuration using a 1.2 kV JFET with 1.4 mΩcm² on-resistance would endure current pulses at 150 to 160 A/cm² resulting in a final temperature increase of 150 K. The initial configuration as for curve A1 would reach this temperature increase after a current pulse with 70 to 80 A/cm². It is clear that the configuration as shown in Figure 4 may be extended for top and/or bottom cooling, i.e. may be extend for the further substrate 5 and/or the heat sink 3. In this case, it is possible for the further substrate 5 to receive a second thermal boundary/electrode.

In Figure 8A to 8D, some main ideas of this disclosure have been illustrated for a 1200 V device. This can be extended to other voltage classes to achieve similar benefit in lowering the device temperature, thereby increasing the operating current density. The benefit could be more evident in low voltage class like a 600 V device, typically used in an event switching application, as the contribution from the thick first layer 11 towards the total device resistance is more at such voltage range. The illustrations have been made using a 600 um thick first SiC layer 11. This could be applied to a standard SiC first layer 11 acting as a substrate having a thickness 11T of about 350 um, where a similar trend in benefit would be observed by using metal filled trenches or vias 1V in the first layer 11 and/or in combination with the heat sink 3 and the further substrate 5.

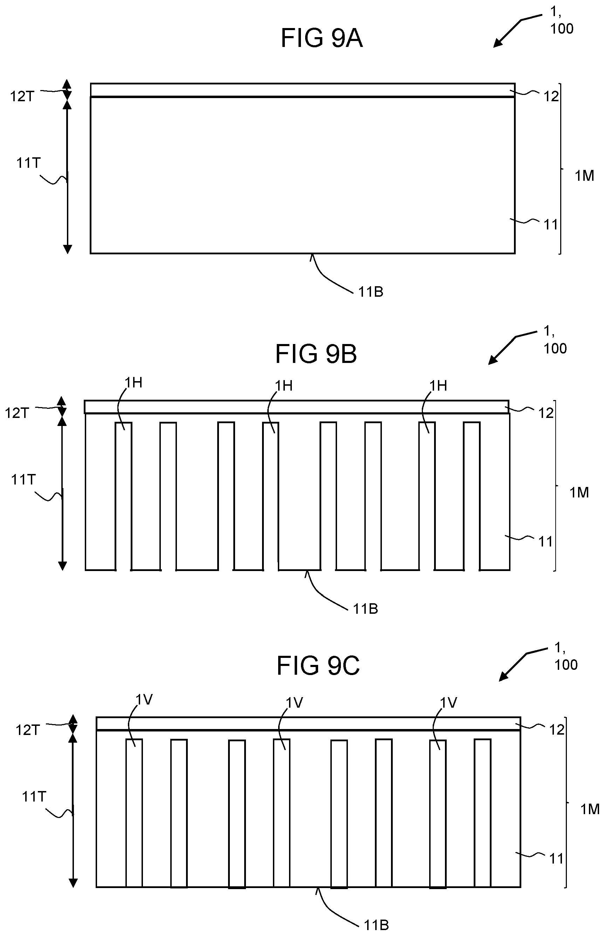

Figures 9A, 9B and 9C show some exemplary method steps of a method for producing at least one assembly 1 for a power semiconductor device 10.

According to Figure 9A, a wafer 100 comprising at least one main body 1M based on SiC is provided, wherein the main body 1M comprises a first layer 11 having a first thickness 11T and a second layer 12 having a second thickness 12T. The second thickness 12T is smaller than the first thickness 11T, wherein the first layer 11 and the second layer 12 are formed from SiC. The first layer 11 has a higher n-doping concentration than the second layer 12. For instance the first layer 11 is formed as a substrate and the second layer 12 as a drift layer of the assembly 1 or of the power semiconductor device 10.

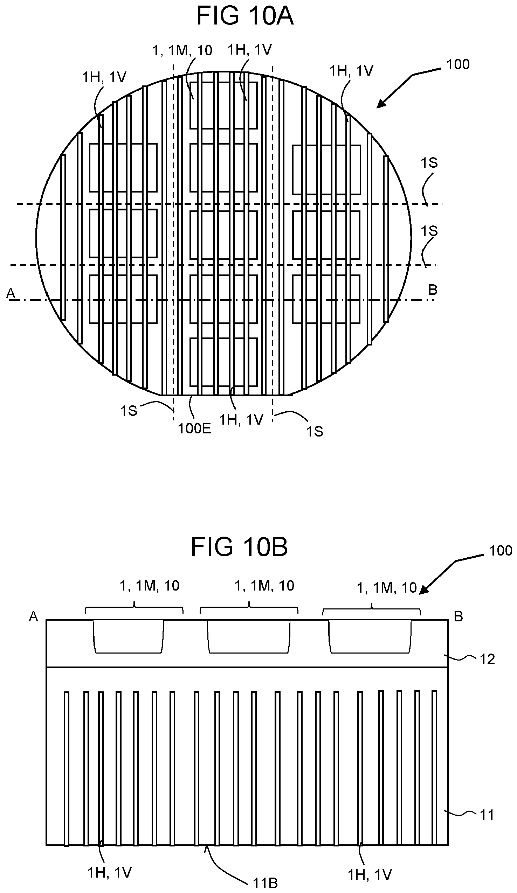

According to Figure 9B, a plurality of trenches 1H extending along a vertical direction from a bottom side 11B of the first layer 11 partially into the first layer 11 towards the second layer 12, wherein the trenches 1H do not extend into the second layer 12. Some possible arrangements of the trenches 1H are described in connection with Figures 10A to 13. The trenches 1H can be formed by a drilling and/or etching process.

According to Figure 9C, the trenches 1H are filled with an electrically conductive material for forming a plurality of vias 1V, wherein the vias 1V extend along the vertical direction from the bottom side 11B of the first layer 11 partially into the first layer 11 towards the second layer 12 and do not extend into the second layer 12. Thus, the vias 1V do not provide a connection between the bottom side 11B and a top side of the first layer 11. In other words, the trenches 1H are not formed as through-holes extending throughout the first layer 11 along the vertical direction. Hence, the vias 1V are not formed as through-vias.

The trenches 1H can be fully filed with the electrically conductive material as shown in Figure 9C. It is, however, possible that the trenches 1H are partly filled with the electrically conductive material. For instance, only inner walls of the trenches 1H are covered with the electrically conductive material. In this case the trenches 1H may comprise regions which are filled with a gaseous medium, for instance with air.

Figure 10A shows a possible arrangement of the trenches 1H or of the vias 1V relative to an edge 100E of the wafer 100 and relative the plurality of the to-be-produced assemblies 1 or power semiconductor devices 10. The trenches 1H or vias 1V extend orthogonal to the edge 100E. In a top view on a bottom side of the wafer, some of the trenches 1H or vias 1V overlap with a plurality of the to-be-produced assemblies 1 or power semiconductor devices 10. The trenches 1H or the vias 1V are parallel to each other. The trenches 1H or the vias 1V can also be formed in regions between the to-be-produced assemblies 1 or power semiconductor devices 10. The trenches 1H or the vias 1V can extend over the entire lateral expansion of the wafer 100.

When the wafer 100 is singulated along singulating lines 1S into a plurality of main bodies 1M, assemblies 1 or power semiconductor devices 10, at least some of the singulating lines 1S cut through the vias 1V so that at least some of the singulated main bodies 1M, assemblies 1 or power semiconductor devices 10 comprise side surfaces which comprise side surfaces of the vias 1V.

Figure 10B show a sectional view of the wafer 100 as shown in Figure 10A along the line AB. In deviation from Figures 10A and 10B, other lateral orientations of the trenches 1H or of the vias 1V are also possible. For example, the trenches 1H or of the vias 1V are parallel to the edge 100E of the wafer, or can form an acute with the edge 100E.

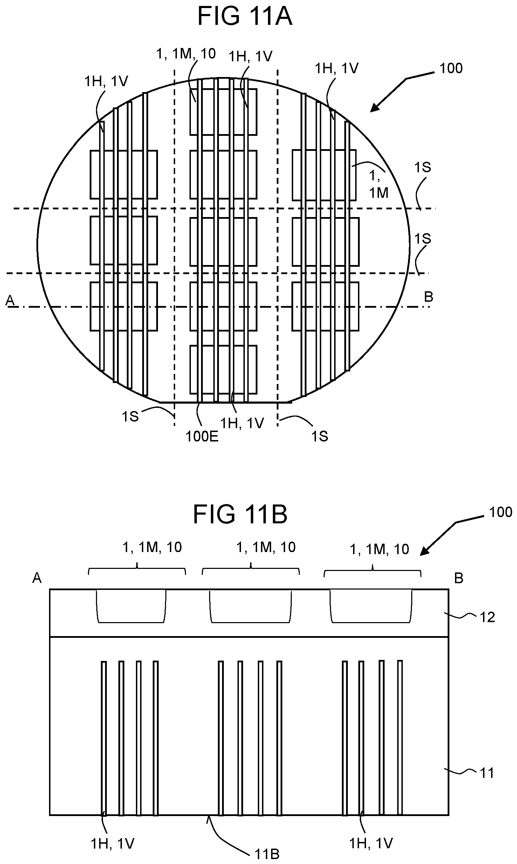

The wafer 100 shown in Figure 11A is basically identical to the wafer 100 with the trenches 1H or vias 1V shown in Figure 10A with the exception that there are no trenches 1H or vias 1V located in regions between the to-be-produced assemblies 1 or power semiconductor devices 10. Thus, it can be ensured that some of the singulating lines do not cut through the trenches 1H or vias 1V. Figure 11B show a sectional view of the wafer 100 as shown in Figure 11A along the line AB.

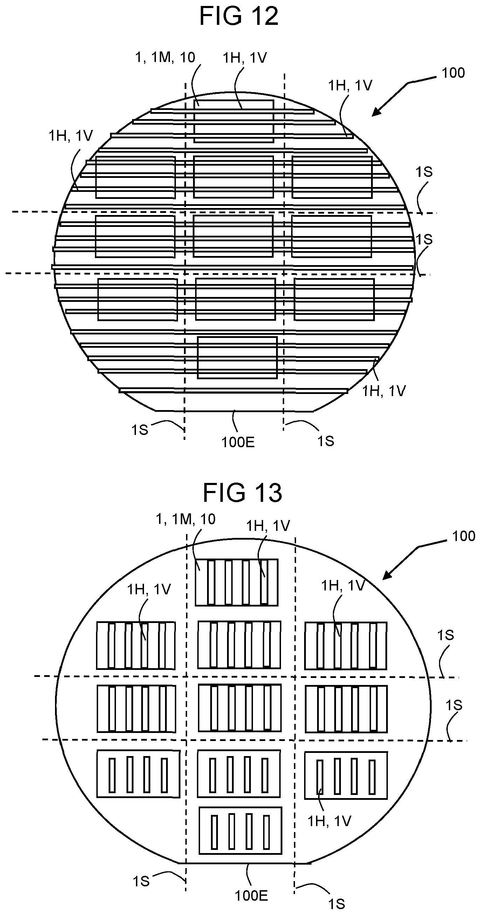

The wafer 100 shown in Figure 12 is basically identical to the wafer 100 with the trenches 1H or vias 1V shown in Figure 10A with the exception that the trenches 1H or vias 1V are parallel to the edge 100E of the wafer.

The wafer 100 shown in Figure 13 is basically identical to the wafer 100 with the trenches 1H or vias 1V shown in Figure 10A with the exception that the trenches 1H or vias 1V are formed only in the regions of the to-be-produced assemblies 1 or power semiconductor devices 10. Thus, in lateral directions, the trenches 1H or vias 1V are fully surrounded by the first layer 11.

According to Figure 13, when the wafer 100 is singulated along the singulating lines 1S into a plurality of main bodies 1M, assemblies 1 or power semiconductor devices 10, none of the singulating lines 1S cuts through the vias 1V so that all side surfaces of all singulated main bodies 1M, assemblies 1 or power semiconductor devices 10 are void of the vias 1V.

In deviation from Figure 13, it is possible that the vias 1V are rotated by an angle of 90° or by another angle, for instance by an angle of 45° ± 10°, 45° ± 15°, 45° ± 20° or 45° ± 30°. As shown in Figure 13, in top view on the bottom side of the first layer 11, the vias 1V can extend over the entire lateral width or the lateral length of the to-be-produced power semiconductor devices 10. The vias 1V can also have a lateral expansion which is smaller than the lateral width and smaller than the lateral length of the to-be-produced power semiconductor devices 10. In deviation from Figure 13, it is also possible that before the step of singulating the wafer 100 into a plurality of power semiconductor devices 10, the vias 1V can have a lateral expansion which is larger than the lateral width and/or the lateral length of the to-be-produced power semiconductor devices 10.

The embodiments shown in the Figures as stated represent exemplary embodiments of an assembly, a power semiconductor device and of a method for producing an assembly for a power semiconductor device; therefore, they do not constitute a complete list of all embodiments according to the improved arrangement for the assembly, power semiconductor device and of the method. Actual arrangements of the assembly, power semiconductor device and of the method may vary from the exemplary embodiments described above.

### Reference signs

- 100: wafer
- 10: power semiconductor device

- 1: assembly
- 1M: main body of the assembly
- 1V: via
- 1H: trench/ hole
- 1S: singulating line

- 11: first layer of the main body
- 11B: bottom side of the first layer
- 11F: first side surface of the first layer
- 11S: second side surface of the first layer
- 11T: first thickness
- 12: second layer of the main body
- 12T: second thickness

- 3: heat sink
- 3T: thickness of the heat sink

- 5: substrate
- 5T: thickness of the substrate

- 100E: edge of the wafer

## Claims

1. An assembly (1) for a power semiconductor device (10) wherein
- the assembly (1) comprises a main body (1M) based on SiC and a plurality of vias (1V) based on an electrically conductive material,
- the main body (1M) comprises a first layer (11) having a first thickness (11T) and a second layer (12) having a second thickness (12T), the second thickness (12T) being smaller than the first thickness (11T),
- the first layer (11) and the second layer (12) are formed from SiC, the first layer (11) having a higher n-doping concentration than the second layer (12), and
- the vias (1V) extend along a vertical direction from a bottom side (11B) of the first layer (11) partially into the first layer (11) towards the second layer (12), the vias (1V) not extending into the second layer (12).

2. The assembly (1) according to claim 1, wherein
- a ratio (11T/12T) of the first thickness (11T) to the second thickness (12T) is from 1.5 to 250,
- the first thickness (11T) is from 100 um to 1000 um, and
- the second thickness (12T) is from 2 um to 200 um.

3. The assembly (1) according to any of the previous claims, wherein
- the first thickness (11T) is larger than or equal 300 um,
- the second thickness (12T) is smaller than or equal to 55 um, and
- a maximal vertical distance between the second layer (12) and the vias (1V) is from 0.6 um to 250 um.

4. The assembly (1) according to any of the previous claims, wherein
- a ratio of an average vertical height of the vias (1V) to the first thickness (11T) of the first layer (11) is at least 0.5, and
- the vias (1V) have a lateral average width between 10 µm and 150 um.

5. The assembly (1) according to any of claims 1 to 4, wherein along lateral directions, the vias (1V) are fully surrounded by the first layer (11).

6. The assembly (1) according to any of claims 1 to 4, wherein the first layer (11) has a first side surface (11F) and a second side surface (11S), wherein along lateral direction, at least one of vias (1V) extends from the first side surface (11F) to the second side surface (11S).

7. The assembly (1) according to any of the previous claims further comprising a heat sink (3) formed from a metal, wherein the main body (1M) is arranged on the heat sink (3), and wherein the heat sink (3) has a vertical thickness (3T) which is larger than a sum of the first thickness (11T) and the second thickness (12T).

8. The assembly (1) according to claim 7, wherein heat sink (3) has a larger cross section than the main body (1M) so that in a plan view of the heat sink (3), the main body (1M) fully overlaps with the heat sink (3).

9. The assembly (1) according to any of the previous claims further comprising a SiC substrate (5), wherein
- the second layer (12) is arranged between the SiC substrate (5) and the first layer (11),
- the SiC substrate (5) has a vertical thickness (5T), a ratio (5T/12T) of the SiC substrate (5) to the second thickness (12T) being from 1.5 to 250, and
- the SiC substrate (5) is void of any vias formed from an electrically conductive material.

10. The assembly (1) according to any of the previous claims, wherein the vias (1V) have cross sections whose sizes vary along the vertical direction, and wherein the size of the cross section of each of the vias (1V) increases with decreasing distance to the bottom side (11B) of the first layer (11).

11. A power semiconductor device (10) comprising an assembly (1), wherein
- the assembly (1) comprises a main body (1M) based on SiC and a plurality of vias (1V) based on an electrically conductive material,
- the main body (1M) comprises a first layer (11) having a first thickness (11T) and a second layer (12), the second thickness (12T) being smaller than the first thickness (11T),
- the first layer (11) and the second layer (12) are formed from SiC, the first layer (11) having a higher n-doping concentration than the second layer (12),
- the vias (1V) extend along a vertical direction from a bottom side (11B) of the first layer (11) partially into the first layer (11) towards the second layer (12), the vias (1V) not extending into the second layer (12), and
- the second layer (12) comprises functional regions configured to carry out functionality of the power semiconductor device (10).

12. The power semiconductor device (10) according to claim 11 which is a MOSFET, JFET, IGBT, Schottky diode, a Junction Barrier Schottky diode or a SiC power device for event switching.

13. A method for producing an assembly (1) for a power semiconductor device (10) comprising:
- providing a wafer (100) comprising at least one main body (1M) based on SiC, wherein the main body (1M) comprises a first layer (11) having a first thickness (11T) and a second layer (12) having a second thickness (12T), the second thickness (12T) is smaller than the first thickness (11T), the first layer (11) and the second layer (12) are formed from SiC, and the first layer (11) has a higher n-doping concentration than the second layer (12),
- forming a plurality of trenches (1H) extending along a vertical direction from a bottom side (11B) of the first layer (11) partially into the first layer (11) towards the second layer (12), wherein the trenches (1H) do not extend into the second layer (12), and
- filling trenches (1H) with an electrically conductive material for forming a plurality of vias (1V), wherein the vias (1V) extend along the vertical direction from the bottom side (11B) of the first layer (11) partially into the first layer (11) towards the second layer (12) and do not extend into the second layer (12).

14. The method according to claim 13, wherein
- the wafer (100) is singulated along singulating lines (1S) into a plurality of main bodies (1M), and
- at least some of the singulating lines (1S) cut through the vias (1V) so that at least some of the singulated main bodies (1M) comprise side surfaces which comprise side surfaces of the vias (1V).

15. The method according to claim 13, wherein
- the wafer (100) is singulated along singulating lines (1S) into a plurality of main bodies (1M), and
- at least some of the singulating lines (1S) do not cut through the vias (1V) so that at least some of the singulated main bodies (1M) comprise all side surfaces being void of side surfaces of the vias (1V).
